(19) Europäisches Patentamt
European Patent Office
Office européen des brevets

(11) **EP 4 726 425 A1**

(12) **EUROPEAN PATENT APPLICATION**
published in accordance with Art. 153(4) EPC

(43) Date of publication:
**15.04.2026 Bulletin 2026/16**

(21) Application number: **24848000.6**

(22) Date of filing: **12.07.2024**

(51) International Patent Classification (IPC):
***G01R 33/06*** (2006.01)   ***G01R 15/20*** (2006.01)

(52) Cooperative Patent Classification (CPC):
**G01R 15/18; G01R 33/0011; G01R 33/0023;
G01R 33/04; G01R 33/05; G01R 33/063;**
G01R 15/20

(86) International application number:
**PCT/CN2024/105241**

(87) International publication number:
**WO 2025/026041 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.08.2023  CN 202310962288
28.08.2023  CN 202311093606**

(71) Applicant: **Innosense Electronics (Shanghai) Co.,
Ltd.
Shanghai 201800 (CN)**

(72) Inventors:
- **MUNOZ, Regis**
  **Shanghai 201800 (CN)**
- **ZHOU, Jiang**
  **Shanghai 201800 (CN)**
- **ZENG, Fenglin**
  **Shanghai 201800 (CN)**
- **WANG, Bowen**
  **Shanghai 201800 (CN)**
- **DANCRE, Jerome**
  **Shanghai 201800 (CN)**

(74) Representative: **Michalski Hüttermann & Partner
Patentanwälte mbB
Kaistraße 16A
40221 Düsseldorf (DE)**

(54) **VARIABLE MAGNETO INDUCTOR, MAGNETIC-FIELD INTENSITY MEASUREMENT METHOD, AND CURRENT MEASUREMENT METHOD**

(57)   Disclosed in the present application are a variable magneto inductor, a magnetic-field intensity measurement method, and a current measurement method. The construction of a measurement unit serves as the variable magneto inductor in the present invention, which measurement unit comprises one or more planar coils or spiral coils as inductor elements, and one or more magnetic materials having a soft magnetic nature. Due to the structural characteristics, the measurement unit in the present invention is equivalent to an inductive component having a variable magnetic permeability, and changes in the magnetic permeability and inductance value thereof are related to the magnitude of a current to be measured in a conductor. The inductive component in the present invention, which may be affected by an electromagnetic field and has a variable magnetic permeability, is named as a variable magneto inductor (V.M.I.).

Fig. 1

**Description**

BACKGROUND OF THE PRESENT INVENTION

FIELD OF INVENTION

The present invention relates to a method for measuring magnetic-field intensity and a method for sampling current, and more particularly to a variable magnetic inductor, a magnetic-field intensity measurement method, and a current measurement method.

DESCRIPTION OF RELATED ARTS

Current sensors are used across various industries such as batteries, converters, chargers, renewable energy, industry, and motor vehicles. At present, the current sensors used for detecting current mainly include shunts, current transformers, Hall-effect sensors, and sensors based on magnetoresistance and fluxgate technologies.

The most widely used are Hall-effect sensors based on the Hall effect, mainly because they offer good reliability and low power consumption, and they also provide non-contact measurement. However, according to the principle of the Hall effect, Hall-effect sensors based on the Hall effect need to use a magnetic core to concentrate the magnetic flux generated by the current to be measured, and the magnetic field formed by the magnetic core needs to be perpendicular to the direction of the current to be measured. Therefore, Hall-effect sensors based on the Hall effect are often relatively large in size. Moreover, when used without a magnetic core, such Hall-effect current sensors are susceptible to EMC interference, resulting in low detection accuracy.

For example, US patent publications US2022260652A1 and US2022357366A1 introduce fluxgate magnetometers to measure current, but these devices are still built around one or more magnetic cores. The main drawbacks of this technology are the need for large, heavy magnetic cores and the high power consumption required to excite the fluxgate secondary.

The patent application published by the World Intellectual Property Organization with publication No. WO2020023127A1, US Patent Publication No. US2011227560A1, and China Publication No. CN114994386A all describe schemes for measuring current using xMR-type current measuring devices. However, these measuring devices are all constructed around one or more magnetoresistive elements. The assembly of these magnetoresistive elements is complex. Furthermore, these patent applications all require construction around a Wheatstone bridge, making such measuring devices susceptible to the skin effect, which can cause significant measurement errors under high current conditions.

SUMMARY OF THE PRESENT INVENTION

An advantage of the present invention is that it provides a variable magnetic inductor, a magnetic-field intensity measurement method, and a current measurement method. The current measurement method measures the current in the conductor under test. Since it does not require a structure around the Wheatstone bridge component for detection, it can avoid errors caused by factors such as large currents, thereby ensuring the accuracy of current detection.

Another advantage of the present invention is to provide a variable magnetic inductor, a magnetic-field intensity measurement method, and a current measurement method. When measuring the current in the conductor under test by the current measurement method of the present invention, since a large magnetic core is not required, the overall weight of the variable magnetic inductor used for measuring the current can be reduced.

Another advantage of the present invention is to provide a variable magnetic inductor, a magnetic-field intensity measurement method, and a current measurement method. Compared with conventional current measurement methods such as fluxgate technology and shunts, the current measurement method of the present invention can greatly reduce power consumption when measuring the current in the conductor under test.

Another advantage of the present invention is to provide a variable magnetic inductor, a magnetic-field intensity measurement method, and a current measurement method, wherein when measuring current through the variable magnetic inductor, since the variable magnetic inductor does not have a heavy magnetic core, the overall mass of the variable magnetic inductor is lighter than that of conventional Hall effect-based sensors.

Another advantage of the present invention is to provide a variable magnetic inductor, a magnetic-field intensity measurement method, and a current measurement method, wherein the variable magnetic inductor has a simple structure and small size.

To achieve at least one of the above advantages, the present invention provides a variable magnetic inductor, wherein the variable magnetic inductor comprises:

at least one inductor element which is connected to an LC oscillation circuit; and

at least one magnetic material having soft-magnetic property, wherein the inductor element is spaced at a predetermined distance from the magnetic material, and when the inductor element is given an excitation pulse voltage of a predetermined duration through the LC oscillation circuit, during an excitation period, the inductor element is defined as an excitation inductor, after the excitation ends, an oscillation current is generated in the inductor element, and during an oscillation period, the inductor element is defined as a receiving inductor.

According to an embodiment, the inductor element is implemented as a planar coil or a helical coil.

According to an embodiment, the variable magnetic inductor comprises at least two inductor elements, wherein the two inductor elements are spaced apart at a predetermined distance from the magnetic material, wherein the two inductor elements are connected to the LC oscillation circuit and are both given the excitation pulse voltage of the predetermined duration, wherein during the excitation period, each inductor element is defined as an excitation inductor, and after the excitation ends, an oscillation current is generated in the two inductor elements, wherein during the oscillation period, each inductor element is defined as a receiving inductor, and the excitation inductor and the receiving inductor are the same inductor element.

According to an embodiment, at least one of the magnetic materials is disposed between a conductor under test and the inductor element to enhance the influence of the magnetic field generated by the current under test in the conductor under test on the variable magnetic inductor.

According to an embodiment, at least one of the magnetic materials is disposed between a magnetic element and the inductor element to enhance the influence of the magnetic field to be measured of the magnetic element on the variable magnetic inductor.

According to an embodiment, the variable magnetic inductor comprises at least two sets of the inductor elements, wherein one set of the inductor elements is aligned with each other and disposed at the same distance from the magnetic material to form at least one excitation inductor, and the other set of the inductor elements is spaced apart from the magnetic material on the other side of the magnetic material to form at least one receiving inductor, wherein the magnetic material disposed between the receiving inductor and the excitation inductor is used to transmit the oscillation wave of the excited current generated by the excitation inductor to the receiving inductor through mutual inductance to form the oscillation current in the receiving inductor.

According to an embodiment, the variable magnetic inductor comprises at least two sets of magnetic materials, wherein the receiving inductor is disposed at intervals between the two sets of magnetic materials, wherein the magnetic material located on the side of the receiving inductor away from the excitation inductor is used to enhance the effect of the magnetic field generated when the current under test passes through the conductor under test on the variable magnetic inductor.

According to an embodiment, the magnetic material having soft-magnetic property is configured as a sheet-like magnetic material.

To achieve at least one of the above advantages, the present invention provides a magnetic-field intensity measurement method, wherein the magnetic-field intensity measurement method comprises the following steps:

apply an excitation pulse voltage to at least one inductor element in any above mentioned variable magnetic inductor, detect at least one of the amplitude and frequency of the oscillation wave of the excitation current generated in the inductor element, and determine the inductance value of the inductor element, wherein the variable magnetic inductor is connected to the LC oscillation circuit;

place the variable magnetic inductor in a magnetic field to be measured, so that the magnetic permeability of the variable magnetic inductor changes under the influence of the magnetic field to be measured, thereby changing the inductance value of the variable magnetic inductor, and in turn changing the amplitude and frequency of the oscillation wave of the current in the inductor element;

based on the relationship between the amplitude or frequency change of the oscillation wave of the current in the inductor element and the magnetic-field intensity of the magnetic field to be measured, determine the magnitude of the magnetic-field intensity of the magnetic field to be measured, which is associated with the amplitude or frequency of the oscillation wave of the current in the inductor element.

To achieve at least one of the above advantages, the present invention provides a current measurement method, wherein the current measurement method comprises the following steps:

apply a pulse voltage to at least one inductor element in any above mentioned variable magnetic inductor, detect at least one of the amplitude and frequency of the oscillation wave of the excitation current generated in the inductor element, and determine the inductance value of the inductor element, wherein the at least one inductor element is connected to the LC oscillation circuit;

bring the variable magnetic inductor close to at least one conductor under test, so that the variable magnetic inductor is affected by the conductor under test, causing the magnetic permeability of the variable magnetic inductor to change, thereby changing the inductance value of the variable magnetic inductor, so as to cause a change in the oscillation wave of the excitation current generated in the inductor element, and the inductance value of the inductor element after being affected by the conductor under test is determined;

based on the relationship between the amplitude or frequency change of the oscillation wave of the current in the inductor element and the current value in the conductor, determine the magnitude of the current in the conductor under test, which is associated with the amplitude or frequency of the oscillation wave of the current in the inductor element.

BRIEF DESCRIPTION OF THE DRAWINGS

FIG. 1 illustrates a partial structural schematic view of a variable magnetic inductor for detecting magnetic-field intensity according to an embodiment of the present invention.

FIG. 2A illustrates a partial structural schematic view of a variable magnetic inductor for detecting magnetic-field intensity in a modified alternative mode of the embodiment shown in FIG. 1 of the present invention.

FIG. 2B illustrates a partial structural schematic view of a variable magnetic inductor for detecting magnetic-field intensity in the modified alternative mode of the embodiment shown in FIG. 2A of the present invention.

FIG. 3A illustrates a partial perspective view of a variable magnetic inductor for detecting magnetic-field intensity according to another embodiment of the present invention.

FIG. 3B is a perspective view illustrating the variable magnetic inductor for detecting magnetic fields in the embodiment shown in FIG. 3A of the present invention.

FIG. 4 illustrates a partial structural schematic view of a variable magnetic inductor for detecting current according to an embodiment of the present invention.

FIG. 5 illustrates a partial structural schematic view of a variable magnetic inductor for detecting current in a modified alternative mode of the embodiment shown in FIG. 4 of the present invention.

FIG. 6 illustrates a partial perspective view of a variable magnetic inductor for detecting current according to another embodiment of the present invention.

FIG. 7 illustrates a partial structural schematic view of a variable magnetic inductor for detecting current in the embodiment shown in FIG. 6 of the present invention.

FIG. 8 is a schematic diagram illustrating the decaying oscillation waveform of the current wave in the receiving inductor as it changes over time.

FIG. 9 is a schematic diagram illustrating the structure of a processor according to the present invention.

FIG. 10 is a partial circuit diagram illustrating a processor according to the present invention.

FIG. 11 are waveform diagrams illustrating the excitation voltage pulse generated by the present invention, the corresponding LC oscillation signal and period frequency after excitation, and the waveform of the change in the current under test.

DETAILED DESCRIPTION OF THE PREFERRED EMBODIMENT

The following description is disclosed to enable any person skilled in the art to make and use the present invention. Preferred embodiments are provided in the following description only as examples and modifications will be apparent to those skilled in the art. The general principles defined in the following description would be applied to other embodiments, alternatives, modifications, equivalents, and applications without departing from the spirit and scope of the present invention.

Those skilled in the art should understand that, in the disclosure of the present invention, terminologies of "longitudinal," "lateral," "upper," "front," "back," "left," "right," "perpendicular," "horizontal," "top," "bottom," "inner," "outer," and etc. that indicate relations of directions or positions are based on the relations of directions or positions shown in the appended drawings, which are only to facilitate descriptions of the present invention and to simplify the descriptions, rather than to indicate or imply that the referred device or element is limited to the specific direction or to be operated or configured in the specific direction. Therefore, the above-mentioned terminologies shall not be interpreted as confining to the present invention.

It is understood that the term "a" or "an" should be understood as "at least one" or "one or more", that is, in one embodiment, the number of an element can be one, while in another embodiment, the number of the element can be multiple, and the term "a" or "an" should not be understood as a limitation on the number.

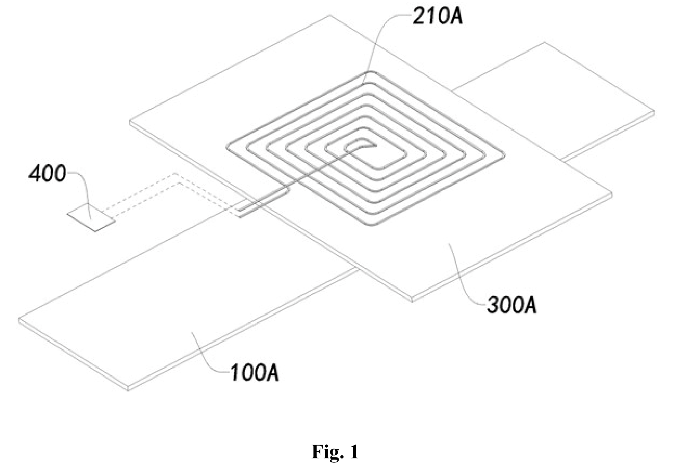

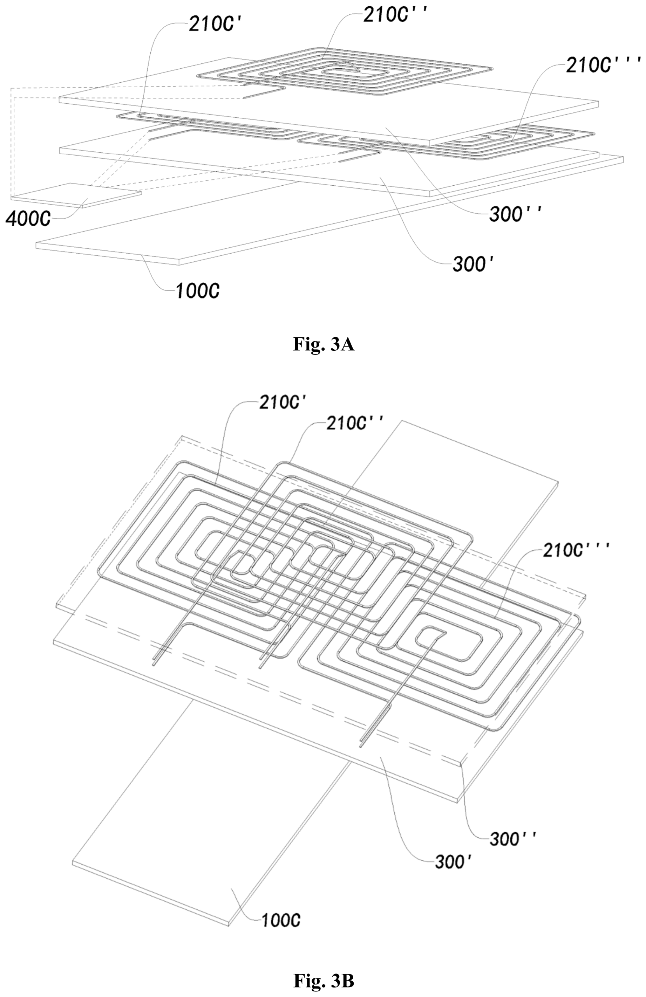

Referring to FIGS. 1 to 3B, a magnetic-field intensity measurement method according to a preferred embodiment of the present invention will be described in detail below, wherein the magnetic-field intensity measurement method comprises the following steps:

S1001, apply an excitation pulse voltage to at least one inductor element in a variable magnetic inductor, detect at least one of the amplitude and frequency of the oscillation wave of the excitation current generated in the inductor element, and determine the inductance value of the inductor element, wherein the variable magnetic inductor is connected to an LC oscillation circuit;

S 1002, place the variable magnetic inductor in the magnetic field to be measured, so that the magnetic permeability of the variable magnetic inductor changes under the influence of the magnetic field to be measured, thereby changing the inductance value of the variable magnetic inductor, and thus changing the amplitude and frequency of the oscillation wave of the current in the inductor element;

S1003, based on the relationship between the change in the amplitude or frequency of the oscillation wave of the current in the inductor element and the magnetic-field intensity of the magnetic field to be measured, determine the magnitude of the magnetic-field intensity of the magnetic field to be measured, which is associated with the amplitude or frequency of the oscillation wave of the current in the inductor element.

In the first embodiment shown in FIG. 1, a variable magnetic inductor is constructed to detect the magnetic-field intensity of the magnetic element 100A in the magnetic field to be measured.

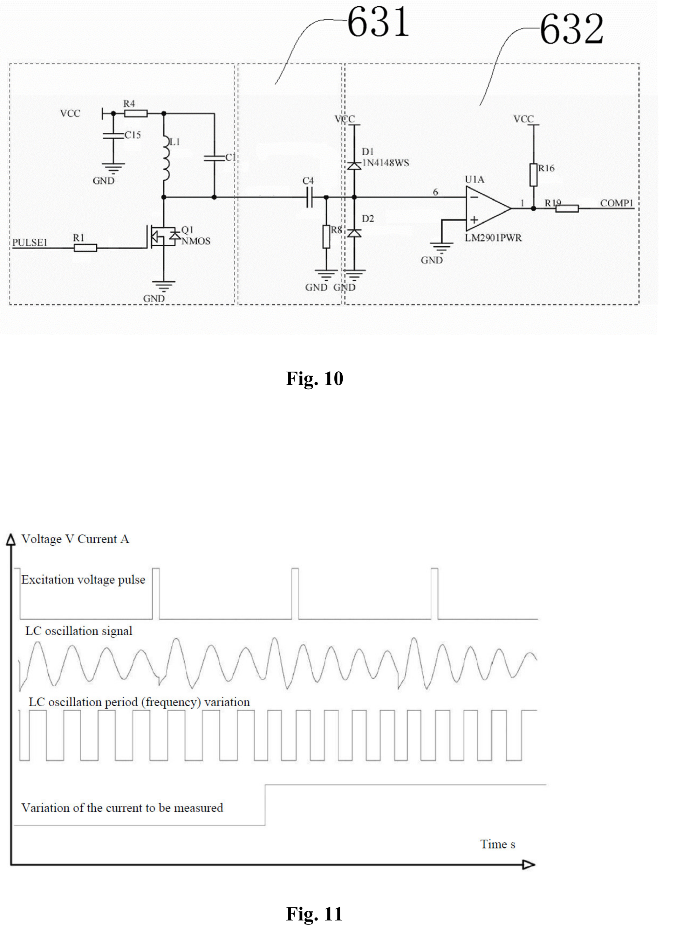

Those skilled in the art will understand that the magnetic element 100A is a component capable of generating a magnetic field which is the magnetic field to be measured. When detecting the magnetic-field intensity of the magnetic field to be measured by the magnetic element 100A, the variable magnetic inductor, particularly the inductor element 210A of the variable magnetic inductor, is positioned within the magnetic field generated by the magnetic element 100A. Referring to FIG. 10, at least one of the inductor elements 210A in the variable magnetic inductor is connected to an LC oscillation circuit.

Those skilled in the art will understand that when the inductor element 210A is placed in the magnetic field, the magnetic permeability of the variable magnetic inductor will change, thereby changing the inductance value of the variable magnetic inductor. This, in turn, will alter the oscillation wave corresponding to the excitation current signal generated in the inductor element 210A, resulting in the altered excitation current signal. There is a difference between the oscillation waves corresponding to the excitation current signal and the altered excitation current signal. That is, the oscillation wave corresponding to the excitation current signal changes under the influence of the magnetic element 100A. By detecting the change in the oscillation wave of the altered excitation current signal relative to the initial oscillation signal, the change in the amplitude and/or frequency of the oscillation wave of the altered excitation current signal relative to the initial oscillation signal in the inductor element 210A can be determined, thereby determining the magnetic-field intensity of the magnetic element 100A.

In one embodiment, the step S 1003 further comprises the following step:
S10031, determine the magnitude of the magnetic-field intensity of the magnetic element by detecting the frequency difference between the oscillation wave of the altered excitation current signal and the oscillation wave of the initial oscillation electrical signal,

Those skilled in the art will understand that the magnetic field of the magnetic element affects the magnetic permeability of the variable magnetic inductor. Based on Faraday's law of electromagnetic induction, the linear relationship between electromotive force and inductance, and other laws, it can ultimately be determined that:

$$L_v = N \times (\Delta \Phi_B / \Delta I_{excit}) = 1 / ((2 \cdot \pi \cdot f)^2 \cdot C) \quad,$$

wherein $L_v$ is the inductance value of the variable magnetic inductor after mutual inductance with the conductor under test;
N is the number of turns of the inductor element 210A;
$\Delta I_{excit}$ is the excitation current value corresponding to the excitation pulse voltage at the corresponding time;
$\Phi_B$ is the magnetic flux of the magnetic element 100A.

It is worth mentioning that, through the above equations and the measured frequency of the oscillation wave of the altered excitation current signal, as well as the values of various parameters, the relationship between the magnetic flux and frequency of the magnetic element100A can finally be determined, namely:

$$f = \frac{1}{2\pi * \sqrt{C * N * (\frac{\Delta \Phi_B}{\Delta I_{excit}})}} \quad,$$

wherein C is the capacitance value of the capacitor connected in parallel or in series with the inductor element 210A.
Preferably, in another embodiment, the step S1003 comprises the following step:
S10032, determine the magnitude of the magnetic-field intensity of the magnetic element 100A by detecting the amplitude difference between the oscillation wave of the altered excitation current signal and the oscillation wave of the initial oscillation electrical signal.
The relation between the inductance value of the inductor element 210A and the amplitude of the oscillation wave of the altered excitation current signal is $u_c = A.\cos(\omega_0.t)$, wherein $\omega_0 = \sqrt{Lv\,C}$,

wherein $u_c$ is the amplitude of the oscillation wave of the current in the inductor element at time t;

wherein A is the peak value of each oscillation of the oscillation wave of the current signal;

wherein C is capacitance value of the capacitor connected in parallel or in series with the inductor element 210A.

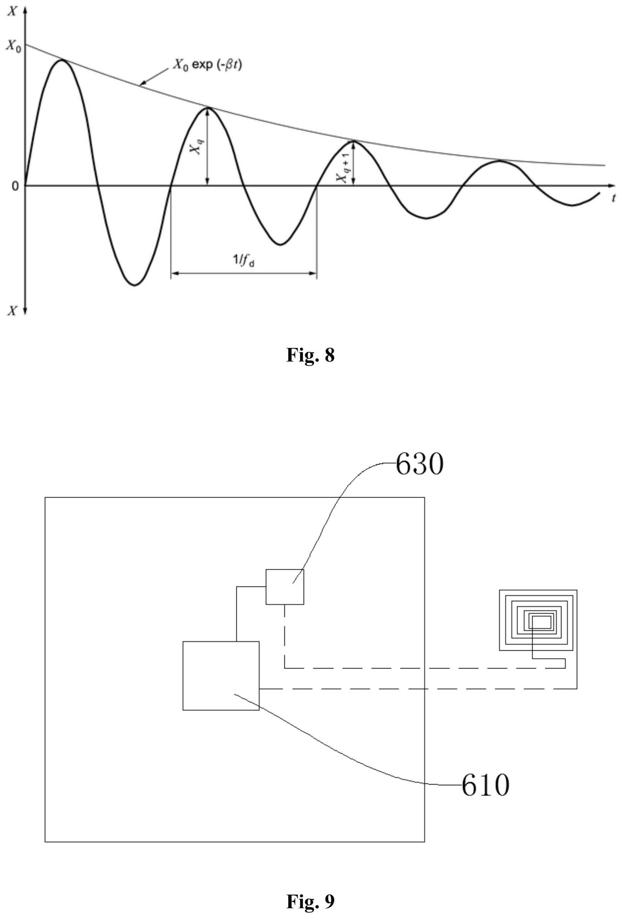

The decaying oscillation wave of the current oscillation in the inductor element 210A as a function of time is as follows:
$X(t) = X_0 \exp(-\beta t) \times \sin 2.\pi. \, fa.t$; as shown in FIG. 8.

$X_0$ is the initial value of the periodic amplitude exponential curve at time zero;

$f_d$ is the frequency of the oscillating wave;

$\beta$ is the damping constant.

The logarithmic attenuation coefficient is expressed based on the damping constant $\beta$ and the frequency $f_d$, and is given by the equation: $A = \beta / f_d$.
The relation between the attenuation factor "tan $\delta$" and the logarithmic attenuation coefficient A is given by the approximate equation tan $\delta \approx A / \pi$.
When the time t is the peak value of a certain oscillation period, X(t) is the peak value A of the oscillation wave of the current in the inductor element 210A in a certain oscillation period. The amplitude $u_c$ at the current time t is obtained by sampling, and then the inductance value $L_v$ of the variable magnetic inductor at the current time t is derived.
Since the magnetic field generated by the magnetic element 100A affects the magnetic permeability of the inductor element 210A, as in the above embodiment, the magnetic flux $\Phi_B$ of the magnetic element 100A can be obtained according to the following formula.

$$L_{\mathrm{v}} = N \times (\Delta\Phi_{\mathrm{B}} / \Delta I_{excit})$$

Based on the above equation, the amplitude $u_c$ measured by sampling, and the values of each parameter, the magnitude of the magnetic-field intensity of the magnetic element 100A can be determined.

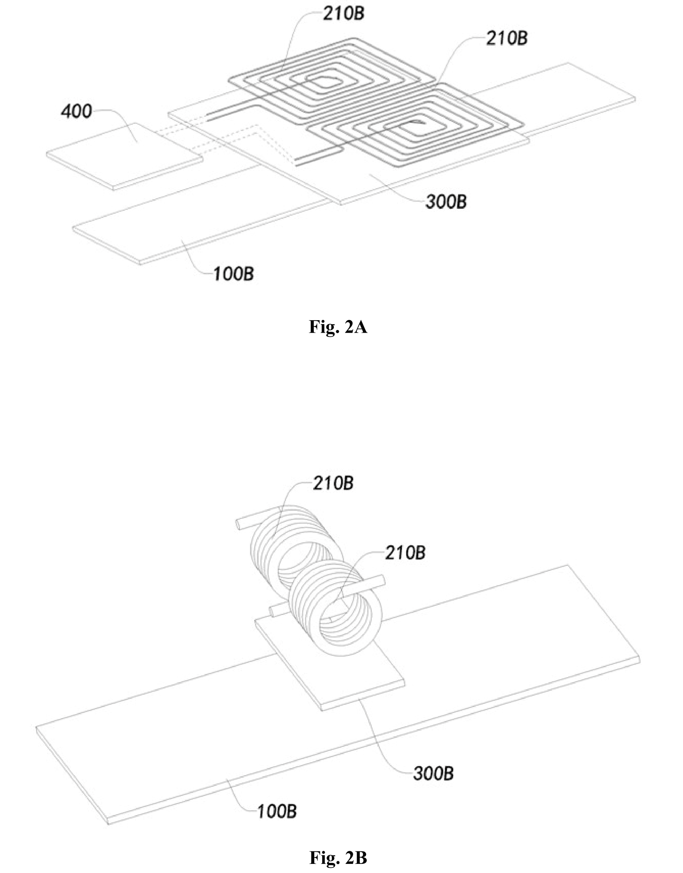

It is worth mentioning that, in any embodiment of the present invention, the inductor element 210A can be implemented as any element with inductive properties, including a coil. To enable those skilled in the art to understand the technical concept of the present invention, in at least one embodiment of the present invention, the inductor element 210A is described only as an example of being implemented as a coil, wherein the shape of the coil can be planar, as shown in FIGS. 1, 2A, and 3, or it can be set as spiral, as shown in FIG. 2B.

To enhance the difference between the excitation current oscillation waves before and after the change, the constructed variable magnetic inductor also comprises a magnetic material 300A, preferably a magnetic material 3000A having soft-magnetic property.

As shown in FIG. 1, the magnetic material 3000A is maintained at a predetermined distance from one side of the inductor element 210A. When detecting the magnetic-field intensity of the magnetic element 100A, the magnetic material 3000A and the inductor element 210A are simultaneously placed in the magnetic field of the magnetic element 100A, and the magnetic material 3000A is held between the magnetic element 100A and the inductor element 210A. In this way, when detecting the magnetic-field intensity of the magnetic field to be measured of the magnetic element 100A, the oscillation wave of the altered excitation current signal in the inductor element 210A within the magnetic field to be measured formed by the magnetic material 3000A will be amplified, thereby increasing the frequency and/or amplitude difference between the oscillation wave of the altered excitation current signal and the oscillation wave of the unaltered excitation current signal, thus facilitating the determination of the magnetic-field intensity of the magnetic element.

More preferably, the magnetic material 300A is constructed as a sheet-like soft magnetic material 3000A, such as a magnetic foil. This allows for the enhancement of the oscillation wave of the current signal while reducing the size and weight of the constructed variable magnetic inductor.

Preferably, in this embodiment, the constructed variable magnetic inductor further comprises a processor 400, wherein the inductor element is electrically connected to the processor 400. The processor 400 is configured to apply the pulse voltage to the inductor element 210A and detect and receive the altered excitation current signal of the inductor element 210A after being affected by the magnetic element. Furthermore, the processor 400 can ultimately determine the magnetic-field intensity of the magnetic element based on the frequency and/or amplitude difference between the oscillation wave of the altered excitation current signal and the oscillation wave of the unaltered excitation current signal.

Referring to FIGS. 2A and 2B, in a modified embodiment, preferably, the constructed variable magnetic inductor comprises two inductor elements 210B. That is, by using two inductor elements 210B, the magnetic-field intensity of the magnetic element 100B can also be detected. In this embodiment, a pulse voltage is applied to the two inductor elements 210B, subsequently causing the inductor elements 210B to self-oscillate.

During detection, the variable magnetic inductor is placed in the magnetic field of the magnetic element 100B, and a pulse voltage is applied to the two inductor elements 210B to generate an excitation current signal in each inductor element 210B. Under the induction of the magnetic element 100B, the inductor element 210B also generates an altered excitation current signal, which is different from the original excitation current signal. By utilizing the frequency and/or amplitude difference between the oscillation wave of the altered excitation current signal and the oscillation wave of the original excitation current signal, the magnetic-field intensity of the magnetic element 100B can be detected.

Preferably, to improve detection accuracy, the constructed variable magnetic inductor also comprises at least one soft magnetic material 3000B, wherein the magnetic material 3000B and the inductor elements 210B do not contact each other. In this way, the magnetic material 3000B effectively amplifies the frequency and/or amplitude difference between the oscillation wave of the altered excitation current signal and the oscillation wave of the unaltered excitation current signal when detecting the magnetic-field intensity of the magnetic element 100B, thereby facilitating detection.

Preferably, the inductor elements 210B are all electrically connected to a processor 400, such as a circuit device including at least one MCU, wherein the processor 400 is used to apply the pulse voltage to the inductor elements 210B and detect the changing current generated by the inductor elements 210B. Furthermore, the processor 400 can subsequently calculate the magnetic-field intensity of the magnetic element 100B.

Alternatively, each inductor element 210B can also be configured as a spiral shape as shown in FIG. 2B.

It is understood that, in the embodiments shown in FIGS. 1 to 2B, the inductor elements included in the constructed variable magnetic inductor serve as both excitation inductors and receiving inductors. Furthermore, initially, a pulse voltage is applied to the two inductor elements 210B, causing them to oscillate for a predetermined duration. After the excitation pulse voltage is stopped, the two inductor elements 210B generate an oscillating excitation current signal through self-induction. In other words, each of the two inductor elements 210B is simultaneously defined as an excitation inductor and a receiving inductor through time-division oscillation.

Similarly, in this embodiment, at least one of the inductor elements 210B in the variable magnetic inductor is connected to an LC oscillation circuit.

Referring to FIGS. 3A and 3B, in another embodiment, the constructed variable magnetic inductor comprises three inductor elements: a first inductor element 210C', a second inductor element 210C", and a third inductor element 210C'''. The first inductor element 210C' and the third inductor element 210C''' are aligned with each other and disposed at the same distance from the magnetic element 100C, such that the magnetic element 100C is held on one side of the first inductor element 210C" and the third inductor element 210C'''. The second inductor element 210C" is disposed spaced apart on the other side of the first inductor element 210C" and the third inductor element 210C'''.

During detection, the variable magnetic inductor is placed within the magnetic field of the magnetic element 100C, and a pulse voltage is applied to the second inductor 210C" to generate an excitation current signal in the second inductor 210C". Under the influence of the magnetic field of the magnetic element 100C, the first inductor 210C' and the third inductor 210C" will generate a modified excitation current signal, different from the original excitation current signal. By utilizing the frequency and/or amplitude difference between the oscillation wave of the modified excitation current signal and the oscillation wave of the original excitation current signal, the magnetic-field intensity of the magnetic element 100B can be detected.

In this embodiment, in the constructed variable magnetic inductor, the second inductor element 210C" is defined as an excitation inductor. Correspondingly, the first inductor element 210C" and the third inductor element 210C''' are both defined as receiving inductors. That is, by applying a pulse voltage to the second inductor element 210C", the first inductor element 210C" and the third inductor element 210C''' generate an altered excitation current signal due to mutual inductance. By utilizing the frequency and/or amplitude difference between the oscillation wave of the altered excitation current signal and the oscillation wave of the unaltered excitation current signal, the magnetic-field intensity of the magnetic element 100C can be detected.

Also preferably, in this embodiment, at least one magnetic material 300' is disposed between the first inductor 210C' and the third inductor 210C''' and the magnetic element 100C. More preferably, at least one magnetic material 300" is also disposed between the first inductor 210C' and the third inductor 210C" ' and the second inductor 210C".

Preferably, the first inductor 210C', the second inductor 210C", and the third inductor 210C''' are all electrically connected to a processor 400C, such as a circuit device including at least one MCU, wherein the processor 400C is used to apply the pulse voltage to the second inductor 210C and detect the altered excitation current signal formed by the first inductor 210C" and the third inductor 210C"'.

It can be understood by those skilled in the art that, through the manner described in the above embodiments, detection of the magnetic-field intensity of the magnetic element 100A/100B/100C can be realized.

Similarly, in this embodiment, at least one of the inductor elements 210C in the variable magnetic inductor is connected to an LC oscillation circuit.

It is worth mentioning that, since the variable magnetic inductor is constructed as shown in FIGS. 1 to 3B does not have a large magnetic core like that of a Hall sensor, the volume and weight of the constructed variable magnetic inductor can be relatively reduced.

Furthermore, in the embodiments shown in FIGS. 1, 2A and 2B, since the inductor element is defined as both an excitation inductor and a receiving inductor due to time-division oscillation, when applying a pulse voltage, it is only necessary to initially apply a pulse voltage of a predetermined duration, rather than continuously applying a pulse voltage. In this way, the power consumption of the constructed variable magnetic inductor during operation can be reduced.

According to another aspect of the present invention, the present invention also provides a current measurement method, the current measurement method comprises the following steps:

S2001, apply a pulse voltage to at least one inductor element in a variable magnetic inductor, and detect at least one of the amplitude and frequency of the oscillation wave of the excited current generated in the inductor element to determine the inductance value of the inductor element;

S2002, bring the variable magnetic inductor close to at least one conductor under test, so that the magnetic permeability of the variable magnetic inductor changes after being affected by the conductor under test, thereby changing the inductance value of the variable magnetic inductor, thereby changing the oscillation wave of the excitation current in the inductor element, and determine the inductance value of the inductor element after being affected by the conductor under test;

S2003, based on the relationship between the change in amplitude or frequency of the oscillation wave of the current in the inductor element and the current value in the conductor, determine the magnitude of the current in the conductor to be measured that is associated with the amplitude or frequency of the oscillation wave of the current in the inductor element.

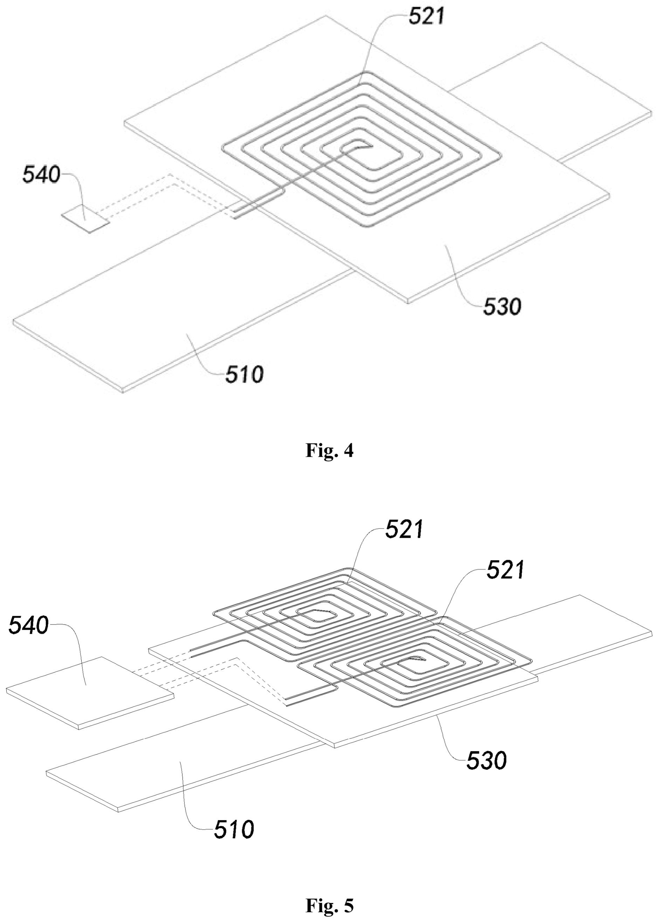

Referring to FIGS. 4 to 7, it can be seen from the above current measurement method that this embodiment also introduces a variable magnetic inductor to detect the magnitude of the current in the conductor 510 under test.

Furthermore, since a magnetic core is not required when detecting the current of the conductor 510 under test employing the variable magnetic inductor, the size and weight of the variable magnetic inductor are reduced.

Furthermore, the step S2003 comprises the following step:

S20031, determine the magnitude of the current in the conductor under test by detecting the frequency difference between the oscillation wave of the altered excitation current signal and the oscillation wave of the initial oscillation electrical signal.

Those skilled in the art will understand that the magnetic field generated by the conductor 510 under test after being energized will affect the magnetic permeability of the variable magnetic inductor. Based on Faraday's law of electromagnetic induction, the linear relationship between electromotive force and inductance, etc., it can ultimately be determined that:

$$L_v = \frac{N \cdot \mu_0 \cdot I_p \cdot S}{2\pi \cdot d \, \Delta I_{excit}} \, ,$$

wherein $L_v$ is the inductance value of the variable magnetic inductor after mutual inductance with the conductor under test;

N is the number of turns of the inductor element 521;

$\Delta_{excit}$ is the excitation current value corresponding to the excitation pulse voltage at the corresponding time.

$\mu_0$ is the vacuum magnetic permeability constant;

$I_p$ is the current in the conductor under test;

S is the cross-sectional area of the plane perpendicular to the magnetic field formed by the inductor element 521;

d is the distance between the conductor 510 under test and the magnetic field formed by the inductor element 521.

$$L_v = N \times (\Delta\Phi_B / \Delta I_{excit}) = 1 / ((2 \cdot \pi \cdot f)^2 \cdot C) \, .$$

It is worth mentioning that, through the above equations and the frequency of the oscillation wave of the altered excitation current signal, as well as the values of various parameters, the value of the current $I_p$ of the conductor under test 510 can finally be determined, that is:

$$f = \frac{1}{2\pi * \sqrt{C * N * (\frac{\mu_0 \cdot I_p \cdot S}{2\pi \cdot d \Delta I_{excit}})}} \, ,$$

wherein C is the capacitance value of the capacitor connected in parallel or in series with the inductor element 521.

Preferably, in another embodiment, the step S2003 comprises the following step:

S20032, determine the magnitude of the current in the conductor under test by detecting the amplitude difference between the oscillation wave of the altered excitation current signal and the oscillation wave of the initial oscillation electrical signal.

The relationship between the inductance value of the inductor element 521 and the oscillation amplitude of the altered excitation current signal is as follows: $u_c = A.\cos(\omega_0.t)$, wherein $\omega_0 = \sqrt{L_v C}$,

wherein $u_c$ is the amplitude of the oscillation wave of the current in the inductor element at time t;

wherein A is the peak value of the oscillation wave of each oscillation of the current signal;

wherein C is the capacitance value of the capacitor connected in parallel or in series with the inductor element 521.

The decaying oscillation wave of the current oscillation in the inductor element 521 as a function of time is as follows:

$X(t)=X_0\exp(-\beta t)\times\sin 2.\pi. f_d.t$, as shown in FIG. 8.

$X_0$ is the initial value of the periodic amplitude exponential curve at time zero;

$f_d$ is the frequency of the oscillating wave;

$\beta$ is the damping constant.

The logarithmic attenuation coefficient is expressed based on the damping constant $\beta$ and the frequency $f_d$, and is given by the equation: $A= \beta / f_d$.

The relation between the attenuation factor "tan $\delta$" and the logarithmic attenuation coefficient A is given by the approximate equation $\tan \delta \approx A / \pi$.

When the time t is the peak value of a certain oscillation period, X(t) is the peak value A of the oscillation wave of the current in the inductor element during that certain oscillation period. The amplitude $u_c$ at the current time t is obtained by sampling, and then the inductance value $L_v$ of the variable magnetic inductor at the current time t is derived.

Because the magnetic field generated by the conductor 510 under test after being energized will affect the magnetic permeability of the inductor, as in the above embodiment, it can ultimately be determined that:

$$L_v = \frac{N \cdot \mu_0 \cdot I_p \cdot S}{2\pi \cdot d\,\Delta I_{excit}} .$$

Based on the above equation and the amplitude $u_c$ measured by sampling, as well as the values of each parameter, the value of the current $I_p$ of the conductor under test can be finally determined.

It is worth mentioning that the current of the conductor under test 510 can be detected by constructing any of the variable magnetic inductors shown in FIGS. 4 to 7.

Referring to FIG. 4, in one embodiment, the variable magnetic inductor comprises at least one of the inductor elements 521.

It is worth mentioning that, in the embodiment shown in FIG. 4, by applying a pulse voltage to the inductor element 521, the magnetic permeability of the variable magnetic inductor will change under the influence of the magnetic field formed by the conductor under test 510. Correspondingly, the inductance value of the variable magnetic inductor will also change. Therefore, the oscillation wave of the excited current signal in the inductor element 521 will change. Using the changed oscillation wave of the current, i.e., the oscillation wave of the altered excited current signal, the current value in the conductor under test 510 can be determined based on the change in the oscillation wave of the altered excited current signal relative to the initial oscillation signal. See the waveform diagram shown in FIG. 11.

As shown in FIG. 5, preferably, a pair of inductor elements 521 in the constructed variable magnetic inductor are given the pulse voltage.

Under the influence of the conductor under test 510, the pair of inductor elements 521 will generate the altered excitation current signal.

It is worth mentioning that, in this embodiment, the inductor elements 521 in each pair are preferably positioned on a plane at the same vertical distance from the conductor 510 under test. Those skilled in the art will understand that, since the variable magnetic inductor has no magnetic core, its volume and weight will be reduced.

More notably, in the embodiments shown in FIGS. 4 and 5, the inductor element 521 serves as both the excitation inductor and the receiving inductor.

Preferably, the variable magnetic inductor further comprises at least one soft magnetic material 530, wherein the magnetic material 530 is disposed at a predetermined distance from the inductor element 521. Similarly, since the magnetic field formed by the disposed magnetic material 530 can amplify the oscillation wave of the altered excitation current signal in the inductor element 521, the frequency and/or amplitude difference between the oscillation wave of the altered excitation current signal and the oscillation wave of the unaltered excitation current signal can be increased. This facilitates the determination of the current magnitude in the conductor 510 under test.

More preferably, the magnetic material 530 is constructed as a sheet-like soft magnetic material, such as a magnetic foil. This allows for enhanced oscillation waves of the current signal while reducing the size and weight of the constructed variable magnetic inductor. Those skilled in the art will understand that the variable magnetic inductor will have a smaller weight and volume compared to conventional Hall effect-based current sensors.

Furthermore, the variable magnetic inductor also comprises a processor 540, such as a circuit device including at least one MCU, wherein the processor 540 is electrically connected to the inductor element 521 to provide the inductor element 521 with the pulse voltage and to detect the current signal of the inductor element 521 during oscillation.

In the embodiments shown in FIGS. 4 and 5, the inductor element included in the constructed variable magnetic inductor serves as both an excitation inductor and a receiving inductor.

Those skilled in the art will understand that, in the embodiments shown in FIGS. 4 and 5, since the inductor element is defined as both an excitation inductor and a receiving inductor due to time-division oscillation, when applying a pulse voltage, it is only necessary to initially apply a pulse voltage of a predetermined duration, rather than continuously applying a pulse voltage. In this way, the power consumption of the constructed variable magnetic inductor during operation can be reduced.

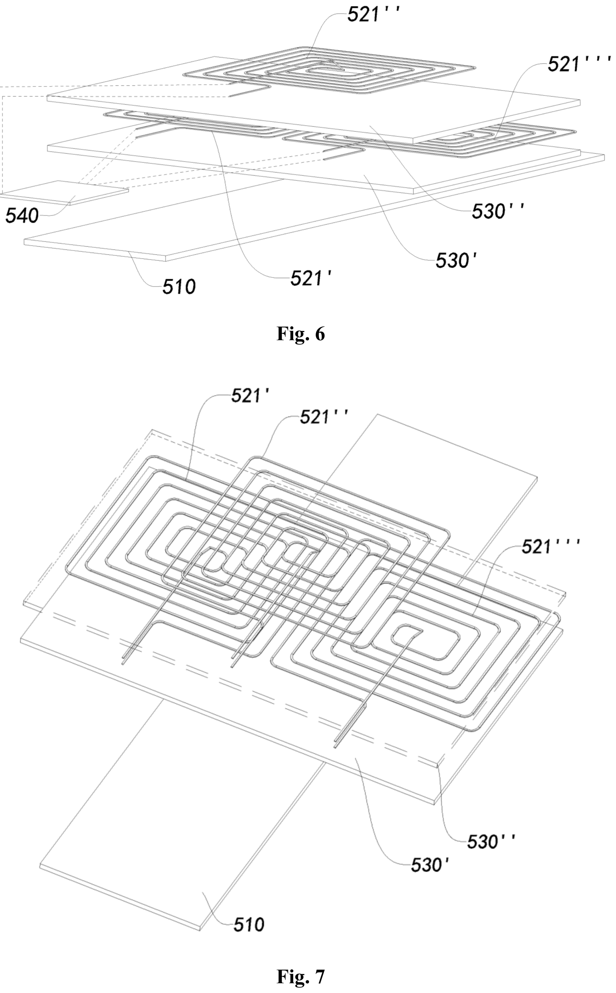

In another modified embodiment shown in FIGS. 6 and 7, the constructed variable magnetic inductor comprises three inductor elements 521, namely a first inductor element 521', a second inductor element 521", and a third inductor element 521"'. The first inductor element 521' and the third inductor element 521"' are aligned with each other and disposed at the same distance from the conductor 510 under test, such that the conductor 510 under test is held on one side of the first inductor element 521" and the third inductor element 521"'. The second inductor element 521" is disposed at a distance from the first inductor element 521" and the third inductor element 521"' at another side of the first inductor element 521" and the third inductor element 521"'.

When detecting the current in the conductor 510 under test, a pulse voltage is applied to the second inductor element 521", thereby defining the second inductor element 521" as an excitation inductor. Correspondingly, the first inductor element 521' and the third inductor element 521"' are both defined as receiving inductors. That is, after applying a pulse voltage to the second inductor element 521", the first inductor element 521" and the third inductor element 521"' generate an altered excitation current signal due to mutual inductance. By detecting the frequency and/or amplitude difference between the oscillation wave of the altered excitation current signal and the oscillation wave of the unaltered excitation current signal, the current in the conductor 510 under test can be detected.

Also preferably, in this embodiment, at least one of the magnetic materials 530' is disposed between the first inductor element 521' and the third inductor element 521"' and the conductor under test 510. More preferably, at least one of the magnetic materials 530" is also disposed between the first inductor element 521' and the third inductor element 521"' and the second inductor element 521".

Preferably, the first inductor element 521', the second inductor element 521", and the third inductor element 521"' are all electrically connected to a processor 540, such as a circuit device including at least one MCU, wherein the processor 540 is used to apply the pulse voltage to the second inductor element 521 and detect the current signal formed by the first inductor element 521' and the third inductor element 521"'. Furthermore, the processor 540 can subsequently calculate the current of the conductor 510 under test.

Preferably, the inductor element can be configured as a planar or spiral shape. Preferably, the inductor element can be configured as a planar shape. Also preferably, the magnetic material is configured as a sheet. This minimizes the size and weight of the variable magnetic inductor.

Referring to FIG. 9, it is worth mentioning that in any of the above embodiments, the processor (400, 540) comprises a processing unit 610 and a signal receiving and extraction unit 630. The processing unit 610 and the signal receiving and extraction unit 630 are electrically connected to the inductor element.

The processing unit 610 applies an excitation voltage, i.e. a pulse voltage, to the inductor element, causing the at least one inductor element to generate the excitation current signal.

When the variable magnetic inductor is used to detect the current in the magnetic element or the conductor under test, the signal receiving and extraction unit 630 extracts the altered excitation current signal.

The processing unit 610 analyzes the excitation current signal and the altered excitation current signal to determine the change in the oscillation wave of the altered excitation current signal relative to the initial oscillation signal, and then determines the magnetic-field intensity of the magnetic element or the current magnitude in the conductor under test.

Referring to FIG. 10, as an example, the signal receiving and extraction unit 630 comprises a high-pass filter circuit 631 and a zero-crossing comparator circuit 632. The processing unit 610, the high-pass filter circuit 631, and the zero-crossing comparator circuit 632 are electrically connected to each other. The high-pass filter circuit 631 is electrically connected to the receiving inductor to acquire the altered excitation current signal in the receiving inductor. The altered excitation current signal is initially an AC signal. The zero-crossing comparator circuit 632 can convert the AC signal into a square wave signal, which is convenient for the subsequent reception and processing by the processing unit 610, as illustrated in the waveform diagram shown in FIG. 11.

Furthermore, the processing unit 610 is electrically connected to the excitation inductor and applies the pulse voltage to the excitation inductor to generate an excitation current signal in the excitation inductor. The processing unit 610 then uses the frequency and/or amplitude difference between the oscillation wave of the altered excitation current signal and the oscillation wave of the unaltered excitation current signal to detect the magnetic strength of the magnetic element or the current of the conductor 510 under test.

In any of the above embodiments, the variable magnetic inductor can be constructed as an electronic component like a chip, thereby enabling the electronic component to implement the technical solutions of any of the above embodiments.

Furthermore, referring to FIG.10, in any of the embodiments shown in FIG. 4 to FIG. 7, at least one of the inductor elements 521 in the variable magnetic inductor is connected in an LC oscillation circuit.

Those skilled in the art should understand that the embodiments of the present invention described above and shown in the accompanying drawings are merely examples and do not limit the invention. The advantages of the present invention have been fully and effectively realized. The functional and structural principles of the present invention have been demonstrated and explained in the embodiments. Any variations or modifications can be made to the implementation of the present invention without departing from these principles.

**Claims**

1. A variable magnetic inductor, **characterized in that** the variable magnetic inductor comprises:

   at least one inductor element which is connected to an LC oscillation circuit; and
   at least one magnetic material having soft-magnetic property, wherein the inductor element is spaced at a predetermined distance from the magnetic material, and when the inductor element is given an excitation pulse voltage of a predetermined duration through the LC oscillation circuit, during an excitation period, the inductor element is defined as an excitation inductor, after the excitation ends, an oscillation current is generated in the inductor element, and during an oscillation period, the inductor element is defined as a receiving inductor.

2. The variable magnetic inductor according to claim 1, **characterized in that** the inductor element is implemented as a planar coil or a helical coil.

3. The variable magnetic inductor according to claim 1 or 2, **characterized in that** the variable magnetic inductor comprises at least two inductor elements, wherein the two inductor elements are spaced apart at a predetermined distance from the magnetic material, wherein the two inductor elements are connected to the LC oscillation circuit and are both given the excitation pulse voltage of the predetermined duration, wherein during the excitation period, each inductor element is defined as an excitation inductor, and after the excitation ends, an oscillation current is generated in the two inductor elements, wherein during the oscillation period, each inductor element is defined as a receiving inductor, and the excitation inductor and the receiving inductor are the same inductor element.

4. The variable magnetic inductor according to claim 1 or 3, **characterized in that** at least one of the magnetic materials is disposed between a conductor under test and the inductor element to enhance the influence of the magnetic field generated by the current under test in the conductor under test on the variable magnetic inductor.

5. The variable magnetic inductor according to claim 4, **characterized in that** at least one of the magnetic materials is disposed between a magnetic element and the inductor element to enhance the influence of the magnetic field to be measured of the magnetic element on the variable magnetic inductor.

6. The variable magnetic inductor according to claim 4, **characterized in that** the variable magnetic inductor comprises at least two sets of the inductor elements, wherein one set of the inductor elements is aligned with each other and disposed at the same distance from the magnetic material to form at least one excitation inductor, and the other set of the inductor elements is spaced apart from the magnetic material on the other side of the magnetic material to form at least one receiving inductor, wherein the magnetic material disposed between the receiving inductor and the excitation inductor is used to transmit the oscillation wave of the excited current generated by the excitation inductor to the receiving inductor through mutual inductance to form the oscillation current in the receiving inductor.

7. The variable magnetic inductor according to claim 6, **characterized in that** the variable magnetic inductor comprises at least two sets of magnetic materials, wherein the receiving inductor is disposed at intervals between the two sets of magnetic materials, wherein the magnetic material located on the side of the receiving inductor away from the excitation inductor is used to enhance the effect of the magnetic field generated when the current under test passes through the conductor under test on the variable magnetic inductor.

8. The variable magnetic inductor according to claim 1, **characterized in that** the magnetic material having soft-magnetic property is configured as a sheet-like magnetic material.

9. A magnetic-field intensity measurement method, **characterized in that** the magnetic-field intensity measurement method comprises the following steps:

applying an excitation pulse voltage to at least one inductor element in the variable magnetic inductor as described in any one of claims 1 to 8, detecting at least one of the amplitude and frequency of the oscillation wave of the excitation current generated in the inductor element, and determining the inductance value of the inductor element, wherein the variable magnetic inductor is connected to the LC oscillation circuit;

placing the variable magnetic inductor in a magnetic field to be measured, so that the magnetic permeability of the variable magnetic inductor changes under the influence of the magnetic field to be measured, thereby changing the inductance value of the variable magnetic inductor, and in turn changing the amplitude and frequency of the oscillation wave of the current in the inductor element;

based on the relationship between the amplitude or frequency change of the oscillation wave of the current in the inductor element and the magnetic-field intensity of the magnetic field to be measured, determining the magnitude of the magnetic-field intensity of the magnetic field to be measured, which is associated with the amplitude or frequency of the oscillation wave of the current in the inductor element.

10. A current measurement method, **characterized in that** the current measurement method comprises the following steps:

applying a pulse voltage to at least one inductor element in the variable magnetic inductor as described in any of claims 1 to 8, detecting at least one of the amplitude and frequency of the oscillation wave of the excitation current generated in the inductor element, and determining the inductance value of the inductor element, wherein the at least one inductor element is connected to the LC oscillation circuit;

bringing the variable magnetic inductor close to at least one conductor under test, so that the variable magnetic inductor is affected by the conductor under test, causing the magnetic permeability of the variable magnetic inductor to change, thereby changing the inductance value of the variable magnetic inductor, so as to cause a change in the oscillation wave of the excitation current generated in the inductor element, and the inductance value of the inductor element after being affected by the conductor under test is determined;

based on the relationship between the amplitude or frequency change of the oscillation wave of the current in the inductor element and the current value in the conductor, determining the magnitude of the current in the conductor under test, which is associated with the amplitude or frequency of the oscillation wave of the current in the inductor element.

**Fig. 1**

**Fig. 2A**

**Fig. 2B**

**Fig. 3A**

**Fig. 3B**

**Fig. 4**

**Fig. 5**

**Fig. 6**

**Fig. 7**

**Fig. 8**

**Fig. 9**

**Fig. 10**

**Fig. 11**

## INTERNATIONAL SEARCH REPORT

International application No.

**PCT/CN2024/105241**

### A. CLASSIFICATION OF SUBJECT MATTER

G01R33/06(2006.01)i; G01R15/20(2006.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 电感器, 振荡, 谐振, 脉冲, 软磁, 铁氧体, LC, inductor, oscillation, oscillating, resonance, syntony, pulse, soft magnet+, ferrite

### C. DOCUMENTS CONSIDERED TO BE RELEVANT

| Category* | Citation of document, with indication, where appropriate, of the relevant passages | Relevant to claim No. |
|---|---|---|
| PX | CN 117706438 A (INNOSENSE ELECTRONICS (SHANGHAI) CO., LTD.) 15 March 2024 (2024-03-15) <br> description, paragraphs [0006]-[0163], and figures 1-11 | 1-10 |
| X | CN 102478646 A (HEFEI INSTITUTES OF PHYSICAL SCIENCE, CHINESE ACADEMY OF SCIENCES) 30 May 2012 (2012-05-30) <br> description, paragraphs [0004]-[0023], and figures 1-2 | 1-5, 8-10 |
| A | US 2014077799 A1 (CALIFORNIA INSTITUTE OF TECHNOLOGY) 20 March 2014 (2014-03-20) <br> entire document | 1-10 |
| A | JP 2016017830 A (ASAHI KASEI ELECTRONICS CO., LTD.) 01 February 2016 (2016-02-01) <br> entire document | 1-10 |

☐ Further documents are listed in the continuation of Box C.    ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **18 September 2024** | **24 September 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/105241**

| Patent document cited in search report | | | Publication date (day/month/year) | Patent family member(s) | | | Publication date (day/month/year) |
|---|---|---|---|---|---|---|---|
| CN | 117706438 | A | 15 March 2024 | None | | | |
| CN | 102478646 | A | 30 May 2012 | None | | | |
| US | 2014077799 | A1 | 20 March 2014 | WO | 2014043656 | A1 | 20 March 2014 |
| | | | | US | 9958510 | B2 | 01 May 2018 |
| JP | 2016017830 | A | 01 February 2016 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2022260652 A1
- US 2022357366 A1
- WO 2020023127 A1
- US 2011227560 A1
- CN 114994386 A